Europäisches Patentamt

European Patent Office

Office européen des brevets

(11) Veröffentlichungsnummer: **0 328 907**

**A1**

(12) **EUROPÄISCHE PATENTANMELDUNG**

(21) Anmeldenummer: 89101299.9

(22) Anmeldetag: 26.01.89

(51) Int. Cl.⁴: **C23F 1/08 , B05B 15/06**

(30) Priorität: **17.02.88 DE 3804878**

(43) Veröffentlichungstag der Anmeldung:
**23.08.89 Patentblatt 89/34**

(84) Benannte Vertragsstaaten:
**AT BE CH DE ES FR GB IT LI NL SE**

(71) Anmelder: **HANS HÖLLMÜLLER
MASCHINENBAU GMBH & CO.
Kappstrasse 69
D-7033 Herrenberg(DE)**

(72) Erfinder: **Baier, Dietfried, Ing.grad.
Sudetenstrasse 7
D-7033 Herrenberg(DE)**
Erfinder: **Grasa, Ivan
Kurzestrasse 12
D-7046 Gäufelden 2(DE)**
Erfinder: **Haas, Rainer, Ing.grad.
Filsstrasse 6
D-7033 Herrenberg(DE)**

(74) Vertreter: **Ostertag, Ulrich et al
Patentanwälte Dr. Ulrich Ostertag Dr.
Reinhard Ostertag Eibenweg 10
D-7000 Stuttgart 70(DE)**

(54) **Maschine zum Ätzen von Gegenständen.**

(57) Bei einer Maschine zum Ätzen von Gegenständen, insbesondere von Platinen für elektronische Schaltungen, sind die Düsen, welche die zu ätzenden Gegenstände mit flüssigem Ätzmittel besprühen, zweiteilig aufgebaut: Ein Düsenkörper ist in unterschiedlichen Drehpositionen am Düsenstock lösbar befestigt. Durch die Winkeleinstellung läßt sich ein bestimmtes Sprühmuster verwirklichen, so daß eine optimale, gleichmäßige Abätzung der Gegenstände gewährleistet ist. Die eigentliche Düsenöffnung, bei der es sich insbesondere auch um einen Schlitz (Fächerdüse) handeln kann, befindet sich an einem gesonderten Düseneinsatz. Dieser Düseneinsatz ist selbst lösbar am Düsenkörper befestigt, diesmal aber nur in einer einzigen Winkelposition gegenüber diesem. Wenn die Düsenöffnung im Betrieb der Maschine verstopft, ist es möglich, zur Reinigung nur den Düseneinsatz zu entfernen, der dann erneut am Düsenkörper befestigt werden kann, ohne daß die vorher eingestellte Winkelposition verloren geht.

Fig.1

## Maschine zum Ätzen von Gegenständen

Die Erfindung betrifft eine Maschine zum Ätzen von Gegenständen, insbesondere von Platinen für elektronische Schaltungen, mit mindestens einem Düsenstock, mit einer Vielzahl von Düsen, die jeweils eine Düsenöffnung und einen Düsenkörper aufweisen, der in unterschiedlichen Winkelstellungen am Düsenstock fixierbar ist, und durch welche die zu ätzenden Gegenstände mit flüssigem Ätzmittel besprühbar sind, mit einer Fördereinrichtung, welche die zu ätzenden Gegenstände an dem Düsenstock vorbeiführt.

Eine derartige Maschine ist in der DE-OS 33 45 124 beschrieben. Hier sind die Düsen einstückig, d.h., die eigentliche Düsenöffnung ist an dem Düsenkörper selbst ausgebildet. Der Düsenkörper wird mittels einer Überwurfmutter in unterschiedlichen Winkelpositionen an dem Düsenstock befestigt, welcher bei der bekannten Ätzmaschine als Platte ausgestaltet ist. Die Einstellbarkeit der Winkelposition der Düsen innerhalb des Düsenstockes hat den Sinn, bei Verwendung von Flachstrahldüsen ein bestimmtes Sprühmuster zu erzielen, bei welchem ein möglichst gleichmäßiges Ätzen der zu behandelnden Gegenstände gewährleistet ist. Setzt sich nun im Betrieb der Ätzmaschine die Düsenöffnung zu, muß die Düse zur Reinigung entfernt werden. Dabei geht selbstverständlich die zuvor erprobte Winkelposition der Düsenöffnung verloren; sie muß mühsam wiedergefunden werden, sofern nicht vorher eine optische Markierung angebracht wurde.

Aufgabe der vorliegenden Erfindung ist es, eine Maschine der eingangs genannten Art derart auszugestalten, daß auch nach dem Herausnehmen der Düsenöffnung zu Reinigungszwecken deren ursprüngliche Winkelposition leicht und präzise wiederauffindbar ist.

Diese Aufgabe wird erfindungsgemäß dadurch gelöst, daß für jede Düse ein Düseneinsatz vorgesehen ist, an dem die Düsenöffnung ausgebildet ist und der in einer und nur einer Winkelstellung an dem Düsenkörper lösbar befestigt ist.

Erfindungsgemäß werden also die Düsen zweiteilig gestaltet: Der Düsenkörper selbst wird, wie bei der bekannten Ätzmaschine, in einer solchen Winkelstellung am Düsenstock befestigt, wie dies zur Erzielung eines optimalen Ätzergebnisses erforderlich ist. Diese Verbindung zwischen Düsenkörper und Düsenstock wird jedoch nachträglich nicht mehr gelöst. Dies wird möglich, weil erfindungsgemäß die eigentliche Düsenöffnung an einem gesonderten Düseneinsatz ausgebildet ist. Dieser Düseneinsatz ist lösbar an dem Düsenkörper befestigt; es ist jedoch Vorsorge getragen, daß diese Befestigung nur in einer ganz bestimmten Position möglich ist. Am einfachsten geschieht dies durch einen geeigneten Formschluß. Sollte nunmehr die Düsenöffnung im Betrieb der Maschine verstopfen, wird nicht mehr die gesamte Düse sondern nur noch der Düseneinsatz aus der Maschine entfernt. Nach der Reinigung der Düsenöffnung kann der Düseneinsatz wieder in die vorherige Winkelposition gebracht werden, ohne daß es erneuter Einstellungsarbeiten oder der Beachtung vorher aufgebrachter Markierungen bedarf.

Zweckmäßigerweise weist der Düsenkörper eine Aufnahme für den Düseneinsatz auf, dessen Querschnitt von einer Kreisform abweicht, wobei der Düseneinsatz zumindest in demjenigen Bereich, der innerhalb der Aufnahme zu liegen kommt, einen entsprechenden Querschnitt aufweist.

Im allgemeinen empfiehlt es sich, wenn zwischen der innenliegenden Stirnseite des Düseneinsatzes und dem Boden der Aufnahme des Düsenkörpers eine Flachdichtung vorgesehen ist.

Der Düseneinsatz kann am Düsenkörper durch eine Überwurfmutter gehalten sein.

Ein Ausführungsbeispiel der Erfindung wird nachfolgend anhand der Zeichnung näher erläutert; es zeigen

Figur 1 einen Axialschnitt durch eine erfindungsgemäße Düse an einem T-Stück, welches Teil eines Düsenstockes ist;

Figur 2 einen Schnitt gemäß Linie II-II von Figur 1.

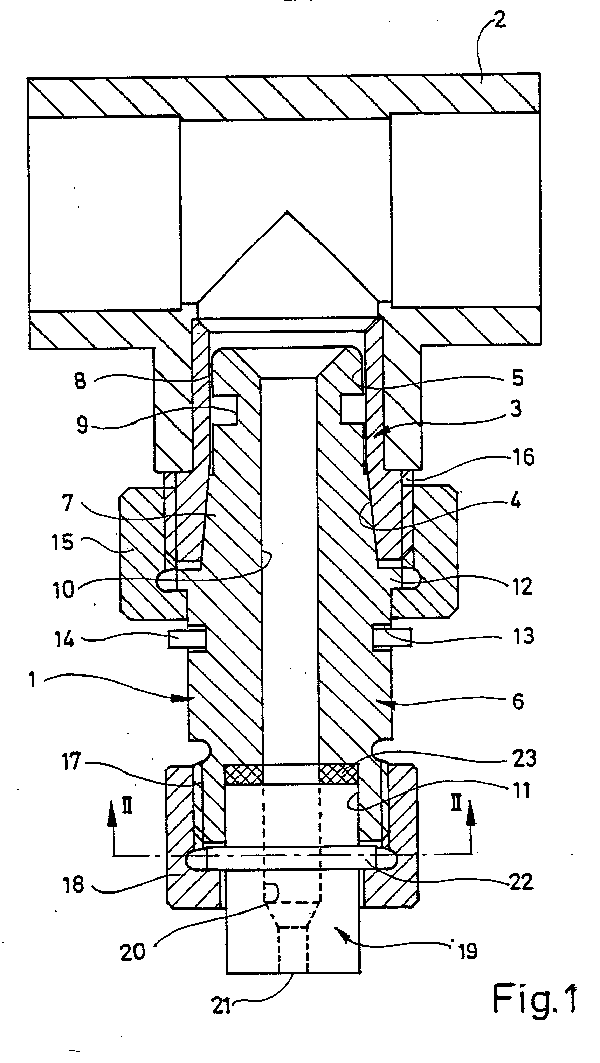

In Figur 1 ist mit dem Bezugszeichen 2 ein T-Stück eines Rohrleitunssystemes dargestellt. Dieses T-Stück ist Bestandteil eines Düsenstockes, an welchem eine Vielzahl von identischen Düsen 1 angeordnet ist und über den den einzelnen Düsen 1 das flüssige Ätzmittel zugeführt wird. In der Abzweigung des T-Stückes 2 ist eine Büchse 3 fest und dicht eingeklebt oder eingeschweißt. Die Innenbohrung der Büchse 3 weist einen oberen, zylindrischen Abschnitt 5 und einen unteren, konischen Abschnitt 5 auf. An dem aus dem T-Stück 2 herausragenden Ende ist die Büchse 3 mit einem Außengewinde 16 versehen. Eine Düse, die insgesamt mit dem Bezugszeichen 1 gekennzeichnet ist, ist mittels einer Überwurfmutter 15, die an einem Außenbund 12 der Düse 1 angreift, an der Büchse 3 und damit an dem zum Düsenstock gehörenden T-Stück 2 befestigt.

Die Düse 1 ist zweiteilig aufgebaut. Ein Düsenkörper 6, an welchem sich der oben erwähnte Ringbund 12 befindet, ist mit einem konischen Abschnitt 7 und einem zylindrischen Abschnitt 8 versehen und mit diesen in die entsprechenden Abschnitte der Innenbohrung der Büchse 3 eingeführt. Die Konuswinkel der Innenbohrung der Büchse 3 und des konischen Abschnittes 7 des Düsenkörpers 6 sind so gewählt, daß sich beim Festdrehen der Überwurfmutter 15 eine Selbstverklemmung ergibt. Im Allgemeinen dichten zudem die aneinanderliegenden konischen Flächen der Innenbohrung der Büchse 3 und des konischen Abschnittes 7 des Düsenkörpers 6 so gut, daß eine gesonderte Dichtung nicht mehr erforderlich ist. Gegebenenfalls kann jedoch eine solche Dichtung in eine Ringnut 9 eingelegt werden, die in den zylindrischen Abschnitt 8 des Düsenkörpers eingeformt ist.

In dem aus der Überwurfmutter 15 herausragenden Bereich ist der Düsenkörper 6 mit einer weiteren Nut 13 versehen. In diese Nut 13 ist ein Sprengring 14 eingesetzt. Der Sprengring 14 dient als Anschlag für die Überwurfmutter 15, so daß beim Herausschrauben der Überwurfmutter 15 der Düsenkörper 6 trotz der Verklemmung in der Büchse 3 herausgezogen werden kann.

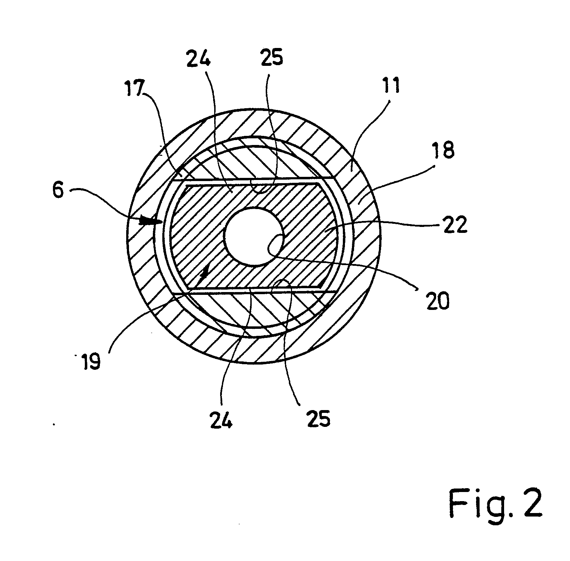

Der Düsenkörper 6 wird von einer axialen Bohrung 10 durchzogen, welche über das T-Stück 2 mit flüssigem Ätzmittel gespeist werden kann. Die axiale Bohrung 10 mündet in den Boden einer Aufnahme 11, die in die äußere Stirnseite des Düsenkörpers 6 eingearbeitet ist. Wie in Figur 2 zu erkennen ist, weist der Querschnitt der Aufnahme 11 eine von einem vollständigen Kreis abweichende Form auf. Im dargestellten Beispiel wird die Aufnahme 11 an gegenüberliegenden Seiten von ebenen Flächen 25 begrenzt.

In die Aufnahme 11 des Düsenkörpers 6 ist ein gesonderter Düseneinsatz 19 eingesetzt, der an dem innerhalb der Aufnahme 11 liegenden Bereich eines radial überstehenden Bundes 22 einen entsprechenden Querschnitt aufweist. Auch dies ist der Figur 2 zu entnehmen. Der Einsatz 19 wird von einer axialen Innenbohrung 20 durchsetzt, welche die Innenbohrung 10 des Düsenkörpers 6 fortsetzt und an der äußeren Stirnfläche des Düseneinsatzes 19 in die eigentliche Düsenöffnung 21 mündet. Die Düsenöffnung 21 weicht von der Kreisform ab, so daß sich eine Art Fächerstrahl bildet, dessen Winkel gegenüber der Förderrichtung von der Winkelausrichtung des Düsenkörpers 6 in dem T-Stück 2 abhängt.

Zwischen dem innerhalb der Aufnahme 11 liegenden Stirnende des Düseneinsatzes 19 und dem Boden der Aufnahme 11 des Düsenkörpers 6 liegt eine Flachdichtung 23, welche das Austreten von Ätzmitteln zwischen Düsenkörper 6 und Düseneinsatz 19 verhindert.

Eine zweite Überwurfmutter 18 greift an dem Bund 22 am Außenumfang des Düseneinsatzes 19 an und ist auf ein Außengewinde 17 des Düsenkörpers 6 aufgeschraubt.

Wenn die Düsenöffnung 21 verstopft, wird der Düseneinsatz 19 nach Lösen der Überwurfmutter 18 aus der Maschine entnommen und gereinigt. Die Winkelposition des Düsenkörpers 6 gegenüber dem T-Stück 2 braucht dabei nicht geändert zu werden, da die Überwurfmutter 15 nicht gelöst wird. Nach der Reinigung wird der Düseneinsatz 19 einfach wieder in die Aufnahme 11 gesteckt und mittels der Überwurfmutter 18 fixiert. Durch die von der Kreisform abweichende Querschnittsform der Aufnahme 11 sowie des entsprechenden Bereiches des Düseneinsatzes 19 ist es ohne weiteres möglich, die ursprüngliche Winkelorientierung der Düsenöffnung 21 wiederzufinden. Das früher als optimal ermittelte Sprühmuster läßt sich somit nach der Unterbrechung, die zur Reinigung der Düsenöffnung 21 erforderlich war, wieder gewinnen.

## Ansprüche

1.) Maschine zum Ätzen von Gegenständen, insbesondere von Platinen für elektronische Schaltungen, mit mindestens einem Düsenstock, mit einer Vielzahl von Düsen, die jeweils eine Düsenöffnung und einen Düsenkörper aufweisen, der in unterschiedlichen Winkelstellungen am Düsenstock fixierbar ist, und durch welche die zu ätzenden Gegenstände mit flüssigem Ätzmittel besprühbar sind, mit einer Fördereinrichtung, welche die zu ätzenden Gegenstände an dem Düsenstock vorbeiführt, dadurch gekennzeichnet, daß für jede Düse (1) ein Düseneinsatz (19) vorgesehen ist, an dem die Düsenöffnung (21) ausgebildet ist und der in einer und nur einer Winkelstellung an dem Düsenkörper (6) lösbar befestigt ist.

2.) Maschine nach Anspruch 1, dadurch gekennzeichnet, daß der Düsenkörper (6) eine Aufnahme (11) für den Düseneinsatz (19) aufweist, dessen Querschnitt von einer Kreisform abweicht, und daß der Düseneinsatz (19) zumindest in demjenigen Bereich, der innerhalb der Aufnahme (11) zu liegen kommt, einen entsprechenden Querschnitt aufweist.

3.) Maschine nach Anspruch 1 oder 2, dadurch gekennzeichnet, daß zwischen der innenliegenden Stirnseite des Düseneinsatzes (19) und dem Boden der Aufnahme (11) des Düsenkörpers (6) eine Flachdichtung (23) vorgesehen ist.

4.) Maschine nach einem der vorhergehenden Ansprüche, dadurch gekennzeichnet, daß der Düseneinsatz (19) am Düsenkörper (6) durch ein Überwurfmutter (18) gehalten ist.

Fig.1

Fig. 2

## Europäisches Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| P,X | DE-U-8 802 030 (H. HÖLLMÜLLER MASCHINENBAU) * Ansprüche 1-4 * --- | 1-4 | C 23 F 1/08 B 05 B 15/06 |
| D,A | WO-A-8 502 631 (H. HÖLLMÜLLER) * Ansprüche 1,6; Figur 3; Seite 1, Zeilen 11-24 --- | 1,4 | |
| A | FR-A-2 188 461 (BERTHOUD S.A.) * Anspruch 1; Seite 1, Zeile 1 - Seite 2, Zeile 8 * --- | 1 | |
| A | DE-A-1 500 603 (SPRYING SYSTEMS CO.) --- | | |
| A | US-A-3 799 453 (D.L. HART) --- | | |
| A | GB-A-2 095 583 (J.D. COOPER) --- | | |
| A | PATENT ABSTRACTS OF JAPAN, Band 8, Nr. 225 (C-247)[1662], 16. Oktober 1984; & JP-A-59 110 781 (TOSHIBA K.K.) 26-06-84 ----- | | |

RECHERCHIERTE SACHGEBIETE (Int. Cl.4)

C 23 F 1/00
B 05 B 15/00

Der vorliegende Recherchenbericht wurde für alle Patentansprüche erstellt

| Recherchenort | Abschlußdatum der Recherche | Prüfer |
|---|---|---|
| DEN HAAG | 12-05-1989 | TORFS F.M.G. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument